(19) Europäisches Patentamt
European Patent Office
Office européen des brevets

(11) EP 2 693 254 A1

(12) EUROPEAN PATENT APPLICATION

(43) Date of publication:
05.02.2014 Bulletin 2014/06

(51) Int Cl.:
G02B 26/08 (2006.01)    B81B 3/00 (2006.01)
G02B 6/35 (2006.01)

(21) Application number: 13178459.7

(22) Date of filing: 30.07.2013

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 03.08.2012 US 201213565948

(71) Applicant: JDS Uniphase Corporation
Milpitas, CA 95035 (US)

(72) Inventor: Jin, Wenlin
Ottawa, Ontario K2G 5W9 (CA)

(74) Representative: McKechnie, Neil Henry et al
Harrison Goddard Foote LLP
Delta House
50 West Nlle Street
Glasgow G1 2NP (GB)

(54) **Mems device with increased tilting range**

(57)     A micro-electro-mechanical (MEMs) devices including a compound hot electrode, which increases the tilting range of the MEMs device. A substantially vertical hot electrode is mounted adjacent to the end or the sides of a pivoting ground electrode, formed of the underside of a pivoting mirror, and combine with a conventional horizontal hot electrode to make up the compound hot electrode.

Figure 4

## Description

## TECHNICAL FIELD

The present invention relates to a pivoting MEMs device, and in particular to a pivoting MEMs device with a compound ground electrode for eliminating unwanted snapping.

## BACKGROUND OF THE INVENTION

The micro electro-mechanical (MEMs) device of the present invention is an electrostatically actuated tilting micro mirror with a torsional spring used for optical switching. When used in fiber optic networks, the MEMs mirrors redirect light signals carrying data from one optical fiber to another in order to reach a desired destination.

In optical switching applications, a micro mirror needs to satisfy three requirements. The first is to enable precise and controllable orientations of the micro mirror, which stems from the fact that imprecise mirror tilt angles might cause the light signals to miss the small fiber cores of the various output optical fibers in the switch causing loss of data during switching. In particular, when the distance between the micro mirror and the fiber is increased, as the demand for higher capacity switches grows, the need for precision becomes paramount.

The second requirement is related to the dynamic response of the mirror to the step voltages used to actuate the mirror. In this aspect, the mirror is required to have minimal overshoot and settling time, which are necessary for minimizing the time between two successive switching operations.

Finally, the magnitude of the step voltage required to drive the micro mirror to the desired tilt angle needs to be minimal to minimize the power requirements of the electric circuits.

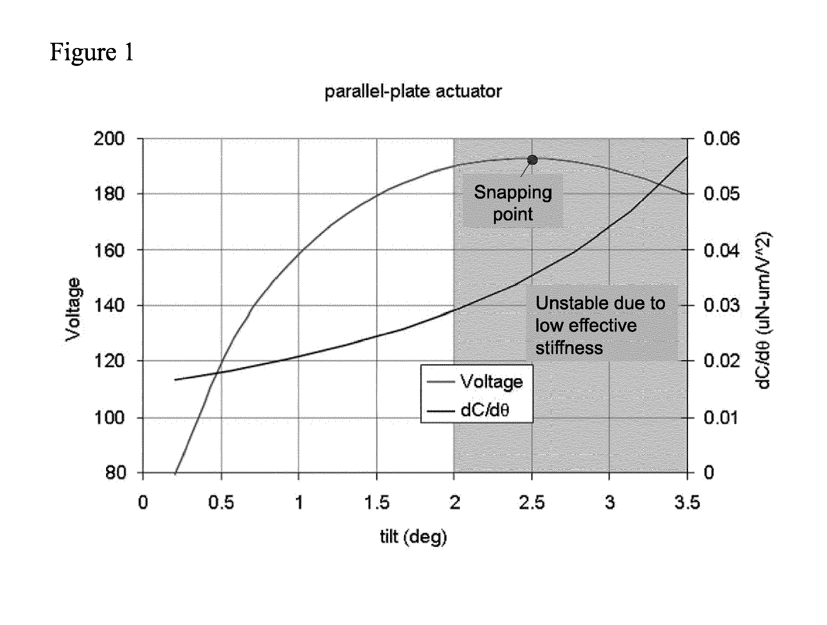

Electrostatic parallel-plate actuators are widely used in MEMS mirror designs because of their simplicity and lateral-force-free property. However, their usable angle range is severely limited by the well-known "snapping" phenomenon, as shown in Figure 1.

The root cause of the snapping is that the electrical driving torque on the mirror with a constant voltage

$$T_e = \frac{1}{2} \frac{dC}{d\theta} V^2$$

increases when mirror angle increase because $dC/d\theta$, i.e. the change in capacitance to the change in mirror angle, is a monotonically-increasing function of mirror angle as shown in Figure 1.

As the result, the mirror response to a external disturbing torque $\Delta T$ becomes

$$\Delta\theta = \Delta T /(K - \frac{1}{2}\frac{d^2 C}{d\theta^2} \cdot V^2) = \Delta T / K_{ef}$$

where $K$ is inherent mechanical stiffness $K$ and $K_{ef}$ is the effective stiffness of the mirror.

When the driving torque increase rate reaches the level that the effective stiffness of the mirror becomes zero, the mirror will continue to rotate without an increase of the driving voltage, i.e. "snapping" occurs, i.e. when $K_{ef}$ reaches zero, the actuator offers no resistant to any driving force increment. Approaching the snap point, the effective stiffness become so small that the mirror tilt is very sensitive to voltage variation and external turbulence. Depending on the stability and control resolution requirements of the application, a large portion of the tilt range near the snapping point become unusable.

An object of the present invention is to overcome the shortcomings of the prior art by providing a parallel-plate actuator having a dC/dΘ, which is a monotonically-decreasing function of Θ, so that the effective stiffness of the actuated mirror remains greater than zero over the whole tilt range, whereby snapping is avoided, the usable tilt angle range is expanded, and tilt stability is improved.

## SUMMARY OF THE INVENTION

Accordingly, the present invention relates to a micro-electro-mechanical device comprising:

a substrate;

a pivoting member mounted above the substrate via a hinge, defining a first axis, for tilting about a tilt range, an underside of the pivoting member defining a ground electrode;

a horizontal hot electrode mounted on the substrate below the pivoting member for attracting the ground electrode towards the substrate, thereby pivoting the pivoting member about the first axis; and

a first vertical hot electrode extending upwardly from the substrate adjacent to and along an edge the pivoting member with a gap therebetween, for increasing an effective stiffness of the pivoting member, whereby the effective stiffness of the pivoting member remains greater than a mechanical stiffness of the pivoting member over the tilt range.

## BRIEF DESCRIPTION OF THE DRAWINGS

The invention will be described in greater detail with reference to the accompanying drawings which represent preferred embodiments thereof, wherein:

Figure 1 illustrates plots of voltage and dC/dΘ vs tilt angle for a conventional MEMs parallel plate actuator;

Figure 2 illustrates the design parameters for a parallel plate actuator;

Figure 3 is an isometric view of an end section of the MEMs pivoting device in accordance with the present invention;

Figure 4 is an isometric view of a MEMs pivoting device in accordance with an alternative embodiment of the present invention;

Figure 5 is an isometric view of a MEMs pivoting device in accordance with an alternative embodiment of the present invention;

Figure 6 illustrates plots of driving voltage and dC/dΘ vs tilt angle for a conventional MEMs pivoting device; and

Figure 7 illustrates plots of driving voltage and dC/dΘ vs tilt angle for a MEMs pivoting device in accordance with the present invention.

## DETAILED DESCRIPTION

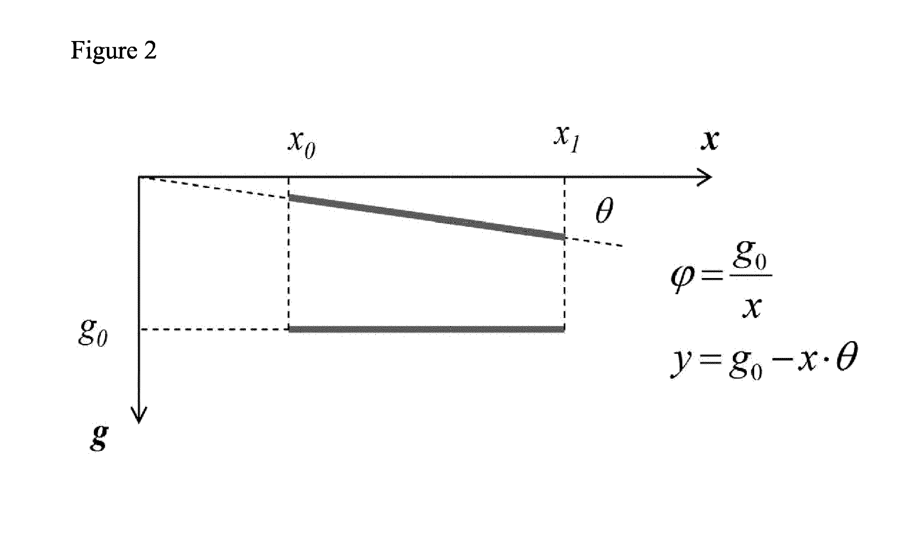

The design parameter definitions for an angular parallel plate actuator are illustrated in Figure 2, in which $g_0$ is the original distance between a hot electrode on the substrate and a ground electrode on pivoting mirror, x is the distance along the ground electrode of the pivoting mirror, and Θ is the angle of the mirror between horizontal and the current position.

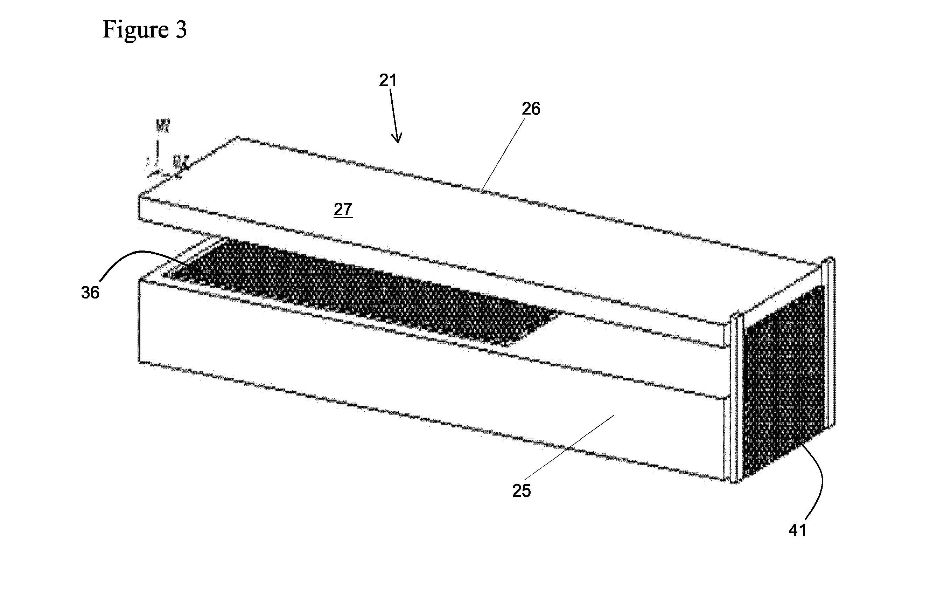

According to the present invention, a micro-electro-mechanical (MEMs) device having a higher effective stiffness is illustrated in Figure 3, 4 and 5. Any form of tilting MEMs device including a pivoting member acting as a ground electrode pivotally mounted over a substrate via a hinge and actuated by a hot electrode below one side thereof, can be used as the basis for the present invention, and the following embodiments are only meant to be exemplary. In particular, any form of hinge structure can be used, including those disclosed in United States Patents Nos. 6,934,439, which is incorporated herein by reference.

With particular reference to Figure 3, a vertical hot electrode 41 is mounted on the substrate 25 beyond (not beneath), but adjacent to and along the outer free end of the tilting platform 26, so that as the mirror platform 26 tilts, the first derivative of capacitance (dC/dΘ), i.e. between the vertical hot electrode 41 and the ground electrode 27, varies in an opposite direction as that between the ground electrode 27 and the horizontal hot electrode 36. By appropriate selection of the geometrical parameters of the vertical electrode 41, the combined 1st derivative of capacitance of the system **decreases** with the tilt of the mirror platform 26 in the whole required range. Typically the vertical hot electrode 41 is substantially perpendicular to the substrate 25, the horizontal hot electrode 36, and the ground electrode 27 of the mirror platform 26, when the mirror platform 26 is parallel to the substrate 25 and the horizontal hot electrode 36. Typically, the vertical hot electrode 41 extends upwardly from the substrate 25 to a height equal to or greater than the gap between the tilting ground electrode 27 and the horizontal hot electrode 36, when the tilting ground electrode 27 is horizontal, i.e. parallel to the horizontal hot electrode 36. The vertical hot electrode 41 can be etched onto the substrate 25 during the fabrication process of the mirror platform 26 or mounted onto the substrate 25 in a subsequent fabrication step..

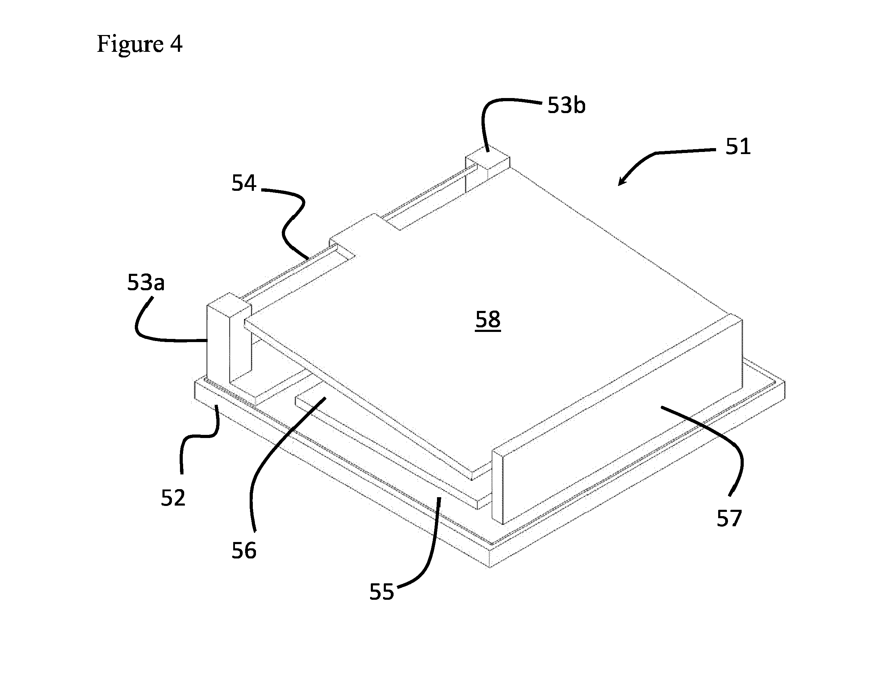

Another embodiment of the present invention is illustrated in Figure 4, in which a uniaxially tilting MEMS device 51 includes a substrate 52 with pedestals 53a and 53b extending upwardly therefrom for supporting torsional hinge 54 extending therebetween defining an axis of rotation. A horizontal hot electrode 56 is mounted on the substrate 52 parallel thereto, while a vertical hot electrode 57 is mounted on the substrate 52 extending upwardly from the substrate 52 perpendicular to the horizontal hot electrode 56. An insulating layer 55 is disposed between the substrate 52 and the hot electrodes 56 and 57. A platform 58 is fixed to the hinge 54 for rotating about the axis of rotation, and is disposed above the horizontal hot electrode 56, generally parallel thereto. The platform 58 acts like a horizontal ground electrode and is rotated to various predetermined angles under control of the horizontal hot electrode 56 by adjusting the voltage thereto, as is well known in the art. Typically, the platform 58 includes a mirrored upper surface for reflecting beams of light or optical signals, used in optical switching devices. The vertical hot electrode 57 comprises a substantially rectangular structure disposed beyond (not beneath), but adjacent to and along the outer free end of the tilting platform 58, for example: extending at least 50% to 150% of the width of the horizontal hot electrode 56 and/or the platform 58, preferably 75% to 125%, and most preferably 90% to 110%. Typically, the vertical hot electrode 57 also extends upwardly from the substrate 52 to a height substantially equal with the platform 58 (when horizontal) or above, i.e. the height of the hinge 54; however, the height can be between 50% to 150% of the height of the gap between the horizontal hot electrode 56 and the horizontal platform 58, preferably 75% to 125%, and most preferably 90% to 110%. The gap between the end of the tilting platform 58 and the vertical hot electrode 57 (when perpendicular) is typically between 1um and 50um, but preferably between 1um and 10 um. The vertical hot electrode 57 can be fabricated, e.g. etched, along with the other elements of the substrate, e.g. pedestals 53a and 53b, or it can be fabricated in a separate step and mounted on the substrate 52 separately.

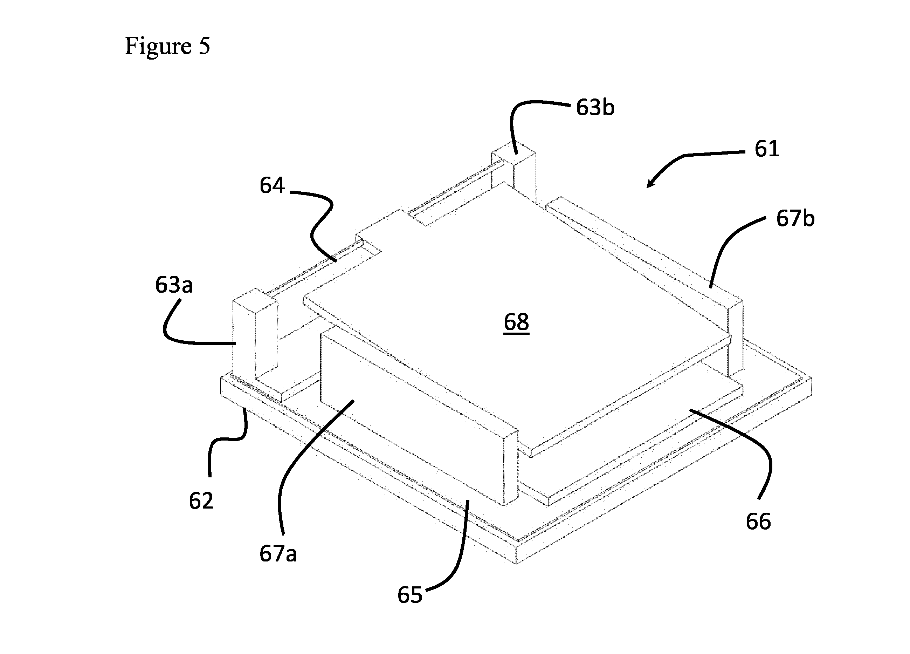

Another embodiment of the present invention is illustrated in Figure 5, in which a uniaxially tilting MEMS device 61 includes a substrate 62 with pedestals 63a and 63b extending upwardly therefrom for supporting torsional hinge 64 extending therebetween defining an axis of rotation. A horizontal hot electrode 66 is mounted on the substrate 62 parallel thereto, while a pair of vertical hot electrodes 67a and 67b are mounted on the substrate 62 extending upwardly from the substrate 62 perpendicular to the horizontal hot electrode 66, adjacent to and along opposite edges of the platform 68. An insulating layer 65 is disposed between the substrate 62 and the hot electrodes 66, 67a and 67b. A platform 68 is fixed to the hinge 64 for rotating about the axis of rotation, and is disposed above the horizontal hot electrode 67, generally parallel thereto. The platform 68 acts like a horizontal ground electrode and is rotated to various predetermined angles under control of the horizontal hot electrode 66 by adjusting the voltage thereto, as is well known in the art. Typically, the platform 68 includes a mirrored upper surface for reflecting beams of light or optical signals, used in optical switching devices. The vertical hot electrodes 67a and 67b are each comprised of a substantially rectangular structure, and are disposed beyond (not beneath), but adjacent and parallel to and along the sides of the tilting platform 68, extending at least half the length of the horizontal hot electrode 66; however, the vertical hot electrodes 67a and 67b can extend from at least 50% to 150% of the length of the horizontal hot electrode 66 and/or the platform 68, preferably 75% to 125%, and most preferably 90% to 110%. Typically, the vertical hot electrodes 67a and 67b extend upwardly from the substrate 62 to a height substantially equal with the platform 68 (when horizontal) or above, i.e. the gap distance $g_0$; however, the height can be between 50% to 150% of the height of the gap between the horizontal hot electrode 66 and the horizontal platform 68, preferably 75% to 125%, and most preferably 90% to 110%. The vertical hot electrodes 67a and 67b can be fabricated, e.g. etched, along with the other elements of the substrate, e.g. pedestals 63a and 63b, or it can be fabricated in a separate step and mounted on the substrate 62 separately.

The 1st derivative of capacitance (dC/dΘ) between vertical hot electrode 57 or 67a/67b and the platform 58 or 68 reduces as the platform 58 or 68 tilt increases, which is opposite to that between horizontal hot electrode 56 or 66 and the platform 58 or 68. By appropriate selection of geometrical parameters, e.g. height and width of the vertical hot electrodes 57 or 67a and 67b, the combined 1st derivative of capacitance of the system 51 or 61 decreases with tilt of the platform 58 or 68 and, therefore, the effective stiffness of the system is greater than the inherent mechanical stiffness in the whole required range.

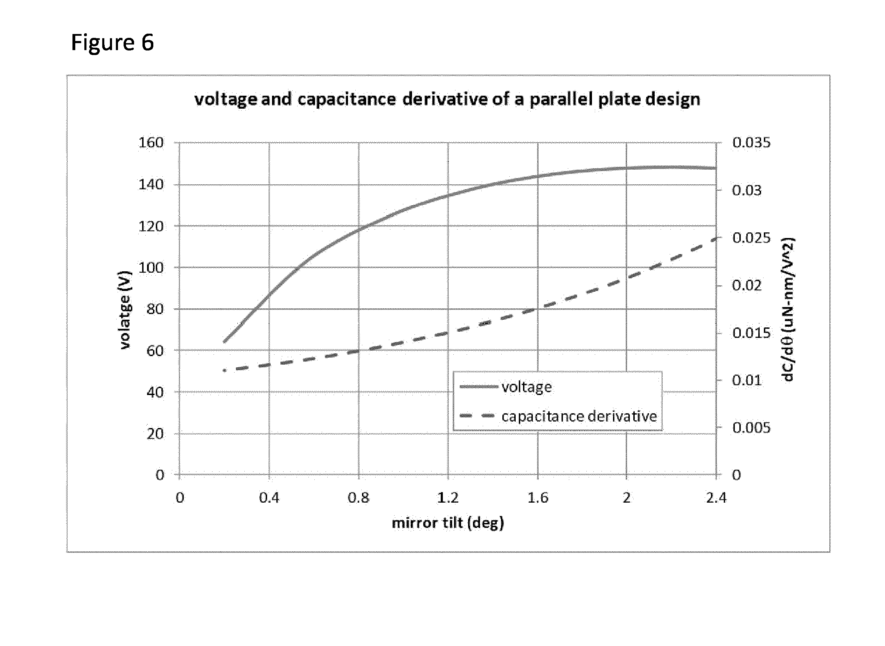

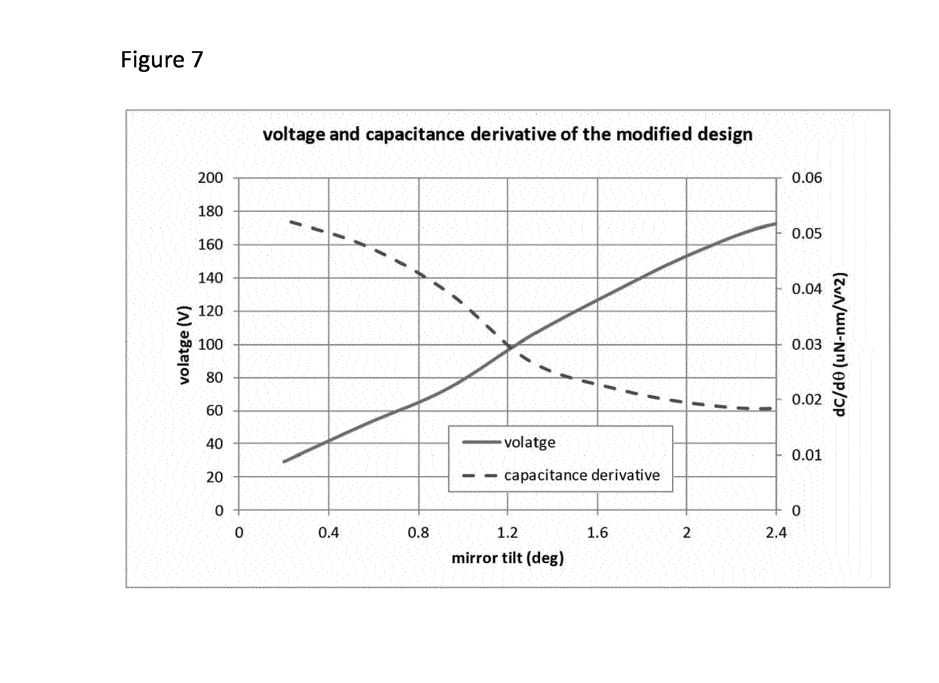

Figures 6 and 7 shows performances before and after, respectively, vertical-electrode modification of an example design. In a standard parallel plate design with a gap (at horizontal position) of 27 um between hot 56 and ground electrode 58, a width of the hot electrode 56 of 95 um and length of 220 um, illustrated in Figure 6, the first derivative (dC/dΘ) increases with tilt angle e, and the snapping point occurs at 2.2° tilt. In the device of the modified design in accordance with the present invention, illustrated in Figure 7, with the parallel plate electrodes having the same dimensions as above, and with a vertical hot electrode, e.g. 57, having a distance to the hinge 54 of 590um, a width of 95um, and a gap between the vertical hot electrode 57 and the platform 58 of 5um, the first derivative (dC/dΘ) of the combined capacitance decrease, i.e. over the operating range of tilt angles after a vertical electrode is added at the end of the platform. As the result, the snapping point disappears and voltage and tilt relationship become linear. Of course, the aforementioned parameters are only meant to be exemplary, and are not to limit the scope of protection in any way.

## Claims

1. A micro-electro-mechanical device comprising:

   a substrate;
   a pivoting member mounted above the substrate via a hinge, defining a first axis, for tilting about a tilt range, an underside of the pivoting member defining a ground electrode;
   a horizontal hot electrode mounted on the substrate below the pivoting member for attracting the ground electrode towards the substrate, thereby pivoting the pivoting member about the first axis; and
   a first vertical hot electrode extending upwardly from the substrate adjacent to and along an edge the pivoting member with a gap therebetween, for increasing an effective stiffness of the pivoting member, whereby the effective stiffness of the pivoting member remains greater than a mechanical stiffness of the pivoting member over the tilt range.

2. The MEMs device according to claim 1, wherein the first vertical hot electrode is substantially perpendicular to the horizontal hot electrode.

3. The MEMs device according to claim 1, wherein the first vertical hot electrode extends upwardly to at least even with pivoting member when the pivoting member is parallel to the horizontal hot electrode.

4. The MEMs device according to claim 1, wherein the tilt range is between 1° and 3°.

5. The MEMs device according to claim 1, wherein the first vertical hot electrode extends adjacent to an outer free end of the pivoting member.

6. The MEMs device according to claim 5, wherein the first vertical hot electrode extends at least 50% of a width of the pivoting member.

7. The MEMs device according to claim 5, where the first vertical hot electrode extends upwardly from the substrate at least 75% to 125% of the distance between the substrate and the pivoting member, when the pivoting member is in a horizontal position.

8. The MEMs device according to claim 1, further comprising a second vertical hot electrode extending adjacent to and along a first side of the pivoting member; wherein the first vertical hot electrode extends adjacent to and along a second side of the pivoting member, parallel to the first side.

9. The MEMs device according to claim 8, wherein each of the first and second vertical hot electrodes extends at least 50% of a length of the pivoting member.

10. The MEMs device according to claim 9, wherein the first and second vertical hot electrodes extend upwardly from the substrate at least 75% to 125% of the distance between the substrate and the pivoting member, when the pivoting member is in a horizontal position.

11. The MEMs device according to claim 1, wherein the gap between the pivoting member and the vertical hot electrode, when perpendicular, is between 1 um and 10 um.

# Figure 1

parallel-plate actuator

EP 2 693 254 A1

Figure 2

EP 2 693 254 A1

Figure 3

Figure 4

Figure 5

EP 2 693 254 A1

Figure 6

voltage and capacitance derivative of a parallel plate design

Figure 7

voltage and capacitance derivative of the modified design

Europäisches
Patentamt

European
Patent Office

Office européen
des brevets

# EUROPEAN SEARCH REPORT

Application Number

EP 13 17 8459

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KUDRLE T D ET AL: "Pull-in suppression and torque magnification in parallel plate electrostatic actuators with side electrodes", TRANSDUCERS, SOLID-STATE SENSORS, ACTUATORS AND MICROSYSTEMS, 12TH INN ATIONAL CONFERENCE ON, 2003, PISCATAWAY, NJ, USA,IEEE, 8 June 2003 (2003-06-08), pages 360-363vol.1, XP032377505, DOI: 10.1109/SENSOR.2003.1215328 ISBN: 978-0-7803-7731-8 * the whole document * | 1-11 | INV. G02B26/08 B81B3/00 G02B6/35 |
| X | EP 2 447 755 A1 (JDS UNIPHASE CORP [US]) 2 May 2012 (2012-05-02) * abstract; figures 3a,3b,5a,5b,6,7 * * paragraphs [0027], [0030], [0035] - [0037] * | 1,2 | |
| A | US 2004/062510 A1 (ROMO MARK GEORGE [US] ET AL) 1 April 2004 (2004-04-01) * paragraphs [0064] - [0066]; figures 12,13 * | 1-11 | TECHNICAL FIELDS SEARCHED (IPC) G02B B81B |

The present search report has been drawn up for all claims

| Place of search | Date of completion of the search | Examiner |
|---|---|---|
| Munich | 6 November 2013 | Blau, Gerd |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 2 693 254 A1**

ANNEX TO THE EUROPEAN SEARCH REPORT
ON EUROPEAN PATENT APPLICATION NO.

EP 13 17 8459

This annex lists the patent family members relating to the patent documents cited in the above-mentioned European search report.
The members are as contained in the European Patent Office EDP file on
The European Patent Office is in no way liable for these particulars which are merely given for the purpose of information.

06-11-2013

| Patent document cited in search report | | Publication date | Patent family member(s) | | Publication date |
|---|---|---|---|---|---|
| EP 2447755 | A1 | 02-05-2012 | EP 2447755 A1<br>US 2012281266 A1 | | 02-05-2012<br>08-11-2012 |
| US 2004062510 | A1 | 01-04-2004 | AU 2003268148 A1<br>CN 1703637 A<br>EP 1546777 A1<br>JP 2006501518 A<br>US 2004062510 A1<br>WO 2004031822 A1 | | 23-04-2004<br>30-11-2005<br>29-06-2005<br>12-01-2006<br>01-04-2004<br>15-04-2004 |

For more details about this annex : see Official Journal of the European Patent Office, No. 12/82

14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6934439 B